# FASCICULE DE BREVET EUROPEEN

(11) **EP 1 559 296 B1**
(45) Date de publication et mention de la délivrance du brevet: **12.04.2006**
(21) Numéro de dépôt: 03778393.3
(22) Date de dépôt: 15.10.2003
(51) Int. Cl.: H05B 3/86, H01Q 1/32, C03C 17/36, B32B 17/06

(54) **VITRE TRANSPARENTE AVEC SURFACE DE CONTACT NON TRANSPARENTE POUR UNE LIAISON PAR BRASAGE**
TRANSPARENTES FENSTER MIT NICHTTRANSPARENTER KONTAKTFLÄCHE FÜR L T-BOND-VERBINDUNG
TRANSPARENT WINDOW WITH NON-TRANSPARENT CONTACT SURFACE FOR A SOLDERING BONDING

(30) Priorité: 26.10.2002 DE 10249992
(43) Date de publication de la demande: 03.08.2005
(73) Titulaire: SAINT-GOBAIN GLASS FRANCE, 92400 Courbevoie (FR)
(72) Inventeur: CRUMBACH, Richard, 52072 Aachen (DE); REUL, Bernhard, 52134 Herzogenrath (DE); SZNERSKI, Andreas, 52499 Baesweiler (DE)
(74) Mandataire: Aupetit, Muriel J. C.
(86) Numéro de dépôt international: PCT/FR2003/003034
(87) Numéro de publication internationale: WO 2004/040944

(56) Documents cités:
- EP-A- 0 281 351
- EP-A- 0 612 119
- DE-A- 4 406 240
- DE-C- 19 536 131
- DE-C- 19 829 151
- US-A- 4 301 189
- US-A- 5 299 726

## Description

L'invention concerne une vitre transparente, en particulier une vitre en verre, présentant au moins une surface de contact électriquement conductrice, non transparente, disposée sur l'une de ses surfaces, pour la relier par brasage à une pièce de raccordement.

De telles vitres sont connues dans de nombreux modes de réalisation. Dans la plupart des applications, les vitres portent sur leur surface des éléments fonctionnels électriques tels que des pistes électriques conductrices, des surfaces chauffantes ou d'antennes, également sous forme de revêtements sur toute la surface, qui doivent être reliés avec au moins une surface de contact à une pièce de raccordement extérieur par brasage.

Souvent, les surfaces de contact (par exemple les pistes conductrices ou selon le cas les éléments fonctionnels eux-mêmes) sont réalisées par application d'une pâte à cuire électriquement conductrice; parfois, on utilise également de minces bandes de feuille métallique étamée qui sont elles-mêmes reliées par brasage à la surface de la vitre qui est le cas échéant pré-étamée. Dans tous ces cas, une pièce de raccordement est appliquée sur la surface de contact par le côté libre et est ensuite brasé.

On connaît également de nombreux modes de réalisation de vitrages composites qui incorporent des éléments fonctionnels électriques entre leurs vitres rigides et qui sont dotés à proximité du bord du vitrage composite de pièces de raccordement électrique à braser du type indiqué au début, et naturellement, on utilise ici des pièces de raccordement si possible plates, qui présentent par exemple la structure décrite dans le document DE-C2 195 36 131. On a également déjà proposé (DE-Cl 198 29 151) de n'apporter la chaleur nécessaire pour le brasage (tendre) par induction ou par faisceau laser qu'après la réalisation du pré-composite. On entend par brasage tendre, l'utilisation d'un métal d'apport pour le brasage qui présente un bas point de fusion, à une température n'excédant pas 450°C.

En règle générale, les pièces de raccordement à braser ou les emplacements de brasage eux-mêmes sont masqués optiquement à l'aide de couches colorées opaques. Dans la plupart des cas d'utilisation habituels, en tant que vitre de fenêtre de véhicule, les vitres sont presque toujours dotées d'une bande de bordure périphérique en forme de cadre en pâte de sérigraphie noire qui convient parfaitement pour masquer également les zones des raccordements électriques. Lesdits rails collecteurs ou les surfaces de contact proprement dites sont déjà non transparent(e)s parce qu'ils/elles sont réalisé(e)s en une pâte de sérigraphie à forte teneur en argent ou, ainsi qu'on l'a indiqué, en bandes de feuille métallique. Du côté de l'habitacle du véhicule, les zones de bordure des vitres ainsi que les brides de montage sur la carrosserie qui les portent sont la plupart du temps recouvertes et masquées par des éléments d'habillage intérieur.

Globalement, pour les vitres transparentes dotées de surfaces de contact, en particulier pour les emplacements de brasage situés à l'intérieur d'un vitrage composite et qui ne sont chauffés qu'après la fabrication de ce composite, se pose le problème de pouvoir vérifier de façon fiable le résultat du brasage à travers la vitre.

Bien que le document EP-B1-281 351 décrive un exemple de réalisation particulier de tels emplacements de brasage dans lequel une surface de contact tramée est réalisée sur un revêtement opaque de la surface d'une vitre en verre à l'aide d'un motif de sérigraphie spécial sur la structure de laquelle le métal d'apport de brasage liquide peut mieux adhérer, un contrôle visuel de ces emplacements de brasage n'est possible que du côté libre de la vitre; à cause du revêtement opaque, le côté arrière de la surface de contact n'est pas visible à travers la vitre proprement dite.

Le problème à la base de l'invention consiste à proposer une solution au problème indiqué ci-dessus.

Selon l'invention, ce problème est résolu en ce que, dans la région de l'emplacement de brasage, la surface de contact présente au moins une découpe par laquelle le métal d'apport de brasage est visible à travers la vitre après le brasage de la pièce de raccordement sur la surface de contact. Les caractéristiques des revendications dépendantes donnent des développements avantageux de cet objet.

Par le fait que dans la surface de contact proprement dite, on forme au moins une fenêtre d'observation qui reste visible à travers la vitre transparente dotée de la surface de contact après le brasage des emplacements des pièces de raccordement, on peut constater par une simple vérification visuelle si le métal d'apport de brasage a fondu et dans quelle mesure. On dimensionnera globalement la quantité de métal d'apport de brasage et l'emplacement de brasage de manière à ce qu'en cas de brasage correct, une partie du métal d'apport de brasage s'écoule de façon optiquement visible dans ladite fenêtre d'observation, ou selon le cas de manière à rendre visible la modification qui résulte de la fusion de la structure superficielle du métal d'apport de brasage. De cette manière, le métal d'apport de brasage après brasage étant répandu sur la surface de contact et éventuellement dans la ou les découpes, le contrôle visuel peut même être le cas échéant automatisé à l'aide de caméras (numériques). La vitre elle-même reste non affectée.

Une découpe, par exemple un trou de 3 à 5 mm de diamètre dans la surface de contact, suffit pour laisser visible la surface étamée de la pièce de raccordement. L'oeil averti d'un vérificateur ou un dispositif optique de surveillance approprié détecte si un brasage complet a eu lieu. Il est évident qu'en cas de besoin, plusieurs de ces découpes peuvent être prévues les unes à côté des autres et être le cas échéant disposées suivant un motif prédéterminé.

Si la surface de contact est appliquée par sérigraphie, on prévoira avantageusement dans le tamis de sérigraphie, à l'endroit du ou des emplacements concernés, un masque approprié qui empêche l'application de la pâte de sérigraphie dans la zone de la découpe. Si la surface de contact est formée par une bande de feuille métallique, on peut découper ou estamper la découpe par des outils appropriés à l'endroit prévu.

Pour un brasage sûr, on peut prévoir d'une part plusieurs petits dépôts de métal d'apport de brasage (en forme de gouttes ou sous forme de couche mince) sur la contre-surface de contact de la pièce de raccordement à braser. Après l'opération de brasage, on peut constater directement par ladite découpe ménagée dans la zone de brasage de la surface de contact si ces dépôts de métal d'apport de brasage ont fondu et coalescé.

Si, pour minimiser l'épaisseur totale de la zone du raccordement (en particulier lorsqu'elle doit être incorporée dans un vitrage composite), on préfère un pré-étamage régulier de la contre-surface de contact (la pièce de raccordement) avec un mince couche de métal d'apport de brasage, alors au moins la structure de la surface étamée se modifie du fait de la fusion. Dans ce cas également, le brasage peut être contrôlé optiquement à travers ladite découpe. Un tel dépôt de métal d'apport de brasage en forme de couche est réalisé sur une épaisseur de quelques micromètres (10 à 15 *µ*m).

Il est aussi possible de déposer en outre des dépôts de métal d'apport de brasage, sous forme d'une mince couche de métal ou sous forme de gouttelettes, sur la surface de contact elle-même, de préférence autour de la ou des découpes.

Comme autre avantage de la ou desdites découpes dans la zone de brasage de la surface de contact, on peut constater qu'une résistance mécanique plus élevée est également conférée à l'emplacement de brasage proprement dit, de sorte que la pièce de raccordement peut résister à des forces de traction plus élevées. Cela constitue un avantage pour la poursuite de la manutention d'une telle vitre lors de son transport et de son montage, parce qu'il est rare que des pièces de raccordement à braser rompues intempestivement puissent être réparées ou selon le cas que la vitre concernée doit être extraite de la série.

Le cas échéant, ainsi qu'on le décrit dans le document DE-C2-195 36, 131 déjà mentionné, on peut prévoir plusieurs surfaces de contact séparées électriquement les unes des autres et disposées les unes à côté des autres, qui seront dotées chacune d'au moins une découpe (de contrôle).

Il est évident que des vitres ainsi équipées ne conviennent pas uniquement comme vitres de fenêtres de véhicules. Dans le domaine de la construction, il existe également de nombreuses applications de vitres dotées d'éléments fonctionnels électriques qui doivent être munis de contacts brasés (par exemple vitrages d'alarme, chauffage de surface, etc.).

D'autres détails et avantages de l'objet de l'invention ressortent des figures d'un exemple de réalisation et de sa description détaillée qui suit.

Sur les figures, et de manière simplifiée et non à l'échelle:
la figure 1 représente une coupe schématique à travers les composants d'un vitrage composite doté d'une surface de contact avec une découpe et d'une pièce de raccordement à braser avant l'assemblage du composite, et
la figure 2 représente en coupe le vitrage composite après l'assemblage et le brasage de l'emplacement de la pièce de raccordement.

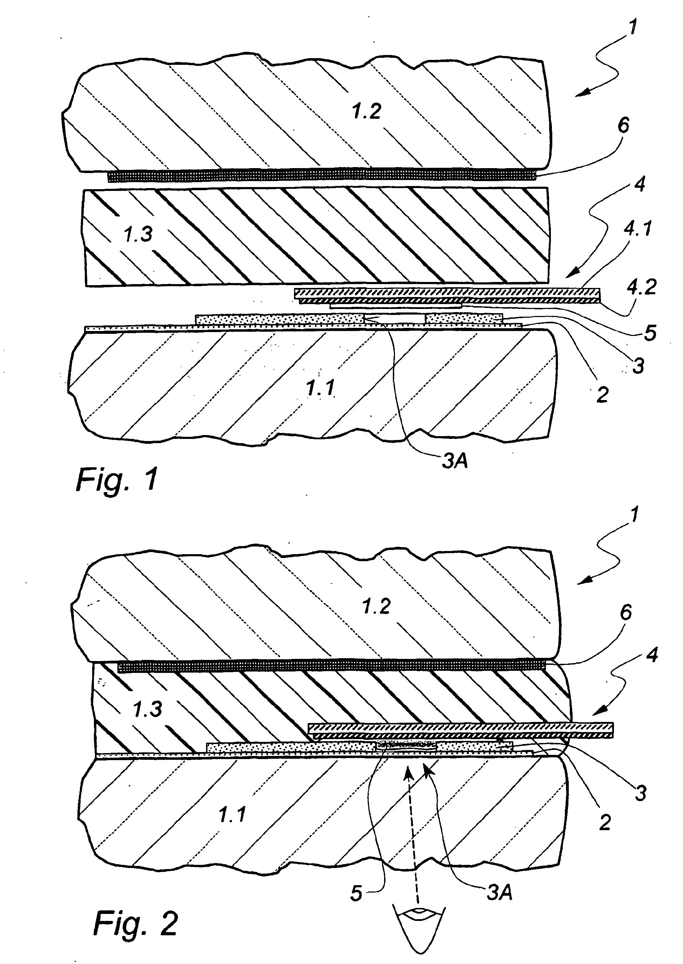

La figure 1 donne une représentation éclatée de la zone de bordure d'un vitrage composite 1 qui est constituée essentiellement d'une première vitre rigide 1.1, d'une deuxième vitre rigide 1.2 ainsi que d'une couche intermédiaire thermoplastique et adhésive 1.3. Les deux vitres rigides sont de préférence réalisées en verre, mais peuvent cependant aussi être réalisées en matière synthétique. La couche intermédiaire est par exemple une feuille de polyvinylbutyral, le matériau adhésif le plus habituel pour les vitrages composites.

Un système 2 en couche mince, hautement transparent pour la lumière visible et apte à être sollicité thermiquement, est appliqué sur la surface plane, tournée vers la couche intermédiaire, de la vitre rigide 1.1. Il comprend au moins une couche fonctionnelle électriquement conductrice, de préférence métallique, ainsi que des couches antiréfléchissantes qui enferment entre elles ladite couche fonctionnelle. La structure plus détaillée du système de couches n'est pas essentielle pour l'invention en question ici, de sorte que l'on ne s'y étendra pas davantage.

Par ailleurs, en plus de son action d'isolation thermique ou selon le cas de réflexion des IR, la couche électriquement conductrice du système de couches 2 sera également utilisée de manière connue en soi comme couche chauffante. Le cas échéant, une fonction d'antenne peut également s'y ajouter. Dans ce but, plusieurs contacts extérieurs doivent être réalisés.

Décrivons maintenant la structure d'une pièce de raccordement individuelle. Sur le système de couches 2, à proximité du bord de la première vitre rigide 1.1, une surface de contact 3 est formée de manière connue d'une pâte à cuire électriquement conductrice et non transparente. Elle est interrompue par une découpe 3A qui, selon l'invention, forme une fenêtre d'observation au milieu de la surface de contact 3.

Le matériau électriquement conducteur de la surface de contact 3 est en liaison électriquement conductrice avec la couche électriquement conductrice du système de couches 2. Cette liaison est réalisée par exemple en chauffant la vitre 1.1 jusqu'à sa température de ramollissement (environ 650°C), le cas échéant en la bombant, après avoir appliqué le système de couches 2 et avoir imprimé la surface de contact 3, et en la laissant ensuite se refroidir. Lors de cette opération de cuisson, on réalise le contact électrique nécessaire.

L'expérience a montré qu'en particulier dans d'autres configurations du système de couches et/ou du matériau de la surface de contact, on peut utiliser des températures largement plus basses, par exemple la température de séchage de la pâte de sérigraphie, d'environ 180°C, pour réaliser le contact électrique. C'est là une plage de températures qui est encore tout à fait supportable, par exemple même pour certaines matières synthétiques en lesquelles la vitre transparente peut être réalisée.

A la différence de ce que l'on a représenté, le système de couches pourrait aussi, également de manière connue en soi, n'être appliqué qu'après l'application de la surface de contact; dans ce cas, il recouvrirait cette dernière en plus de la découpe. La mise en contact électrique est alors également assurée, parce que les micro-irrégularités de la surface de contact traversent le système de couches extrêmement mince (épaisseur dans la plage des nanomètres).

En général, la structure de conducteur représentée ici comme surface de contact 3 est habituellement un rail dit collecteur qui s'étend parallèlement au bord de la vitre 1.1 et pratiquement sur toute sa longueur, et qui permet l'apport ou selon le cas le prélèvement régulier d'un courant dans la couche 2. Suivant la fonction, plusieurs pièces de raccordement à braser peuvent également être prévues sur un tel rail collecteur.

Au-dessus de la découpe 3A se trouve l'extrémité d'une pièce de raccordement à braser 4 qui doit être prolongée latéralement hors du composite et qui ici est configurée comme conducteur plat avec une feuille support 4.1 en matière synthétique et (au moins) un conducteur métallique en feuille 4.2. Une mince couche 5 de métal d'apport de brasage tendre est appliquée localement sur ce dernier, dans les limites de la zone de brasage proprement dite. Elle forme le dépôt de métal d'apport de brasage pour le brasage de la pièce de raccordement à braser 4 à la surface de contact 3. En règle générale, la taille de la surface à braser est comprise entre 100 et 400 mm². Cela permet de transmettre également de manière sûre des courants de chauffe relativement élevés.

Enfin, sur le côté tourné vers la couche intermédiaire 1.3 de la surface de l'autre vitre rigide 1.2, on forme une bande de bordure opaque 6 en pâte à cuire non transparente. Lorsque le vitrage composite se trouve dans son état final (Fig. 2), elle masque optiquement vers l'extérieur l'emplacement de brasage ou selon le cas la surface de contact 3.

La figure 2 est une vue en coupe des composants représentés dans la figure 1 après assemblage et liaison des couches ou selon le cas des vitres du vitrage composite 1 et la réalisation de la pièce de raccordement à braser. On peut voir en outre que la fusion et la compression de la couche intermédiaire 1.3 sur le bord de la vitre scellent de manière étanche les surfaces situées plus loin vers l'intérieur. La pièce de raccordement à braser 4 s'étend vers l'extérieur depuis l'emplacement de brasage et elle est entouré de tous côtés de manière étanche par le matériau de la couche intermédiaire. Si nécessaire, la zone située entre le côté inférieur de la pièce de raccordement à braser 4 et la surface de la vitre peut être fermée par ailleurs à l'aide d'un matériau approprié d'étanchéité et/ou d'adhérence. Rappelons ici que l'on a choisi une représentation très simplifiée.

On peut voir en coupe que le métal d'apport de brasage tendre de la couche mince 5 a été fondu, par exemple par apport de chaleur par induction, et que, par la pression qui agit à l'intérieur du vitrage composite, il s'est écoulé jusque dans la découpe 3A. Le métal d'apport de brasage ne doit en l'occurrence pas entrer en contact avec la surface du système de couches 2. On dimensionnera la quantité de métal d'apport de brasage du dépôt de métal d'apport de brasage de telle sorte que la surface de brasage souhaitée soit obtenue de manière exacte et sûre. Ce résultat du brasage, à savoir la modification de la couche de métal d'apport de brasage, est détectable sans problème à l'oeil nu à travers la vitre 1.1, ainsi qu'on l'a indiqué, parce que la vitre rigide 1.1 et le système de couches 2 sont transparents. Le contact entre le métal d'apport de brasage et les flancs latéraux de la découpe entraîne simultanément une adhérence accrue du métal d'apport de brasage au matériau de la surface de contact.

Bien que le mode de réalisation décrit ci-dessus puisse être utilisé de manière particulièrement avantageuse sur des vitrages composites qui présentent la configuration indiquée, il n'est pas exclu de prévoir une découpe du type et avec la fonction expliqués ici également dans des surfaces de contact à braser sur des vitres monolithiques.

## Revendications

1. Vitre transparente (1.1), en particulier une vitre en verre, présentant au moins une surface de contact (3) électriquement conductrice, non transparente, disposée sur l'une de ses surfaces, pour la relier par brasage à une pièce de raccordement (4), **caractérisée en ce que** dans la région de l'emplacement de brasage, la surface de contact (3) présente au moins une découpe (3A) par laquelle le métal d'apport de brasage (5) est visible à travers la vitre (1.1) après le brasage de la pièce de raccordement (4) sur la surface de contact (3).

2. Vitré selon la revendication 1, **caractérisée en ce que** sur sa surface, plusieurs surfaces de contact et/ou plusieurs découpes sont prévues dans chaque surface de contact.

3. Vitre selon la revendication 1 ou 2, **caractérisée en ce que** le métal d'apport de brasage (5) après brasage est répandu sur la surface de contact (3) et dans la ou les découpes (3A).

4. Vitre selon l'une quelconque des revendications précédentes, **caractérisée en ce que** la pièce de raccordement (4) est munie avant brasage de dépôts (5) de métal d'apport de brasage qui se présentent sous forme de gouttelettes ou d'une couche mince.

5. Vitre selon l'une quelconque des revendications précédentes, **caractérisée en ce que** la surface de contact (4) est munie avant brasage, de préférence autour de la ou des découpes (3A), de dépôts (5) de métal d'apport de brasage qui se présentent sous forme de gouttelettes ou d'une couche mince.

6. Vitre selon l'une quelconque des revendications précédentes, **caractérisée en ce qu'**entre la surface de la vitre (1.1) et la surface de contact (3) ou au-dessus de la surface de contact dotée de la découpe est appliqué un système de couches (2) transparent à la lumière visible, qui comprend au moins une couche électriquement conductrice qui est reliée de manière électriquement conductrice à la surface de contact (3).

7. Vitre selon la revendication 6, dont le système de couches (2) est utilisé comme chauffage de surface et présente un contact électrique.

8. Vitre selon la revendication 6 ou 7, dont le système de couches (2) est utilisé comme antenne et présente un contact électrique.

9. Vitre (1.1) selon l'une des revendications précédentes, incorporée comme vitre rigide dans un vitrage composite (1), la surface de contact (3) au moins et l'emplacement de brasage étant situés à l'intérieur du composite de vitres.

10. Vitrage composite (1) présentant une première vitre rigide (1.1) selon l'une quelconque des revendications précédentes et au moins une deuxième vitre rigide (1.2), **caractérisé en ce que** la deuxième vitre rigide (1.2) est dotée d'un revêtement opaque (6) qui recouvre la surface de contact (3) et le masque optiquement.

## Claims

1. A transparent pane (1.1), in particular a glass pane, having at least one electroconducting, non-transparent contact surface (3) placed on one of its surfaces, in order to connect it by soldering to a connection piece (4), **characterized in that**, in the region of the soldering location, the contact surface (3) has at least one cutout (3A) via which the soldering filler metal (5) is visible through the pane (1.1) after the connection piece (4) has been soldered to the contact surface (3).

2. The pane as claimed in claim 1, **characterized in that**, on its surface, several contact surfaces and/or several cutouts are provided in each contact surface.

3. The pane as claimed in claim 1 or 2, **characterized in that** the soldering filler metal (5), after soldering, is spread over the contact surface (3), and in the cutout or cutouts (3A).

4. The pane as claimed in any one of the preceding claims, **characterized in that** the connection piece (4) is provided, before soldering, with deposits (5) of soldering filler metal that are present in the form of droplets or of a thin layer.

5. The pane as claimed in any one of the preceding claims, **characterized in that** the contact surface (4) is provided, before soldering, preferably around the cutout or cutouts (3A), with deposits (5) of soldering filler metal that are present in the form of droplets or of a thin layer.

6. The pane as claimed in any one of the preceding claims, **characterized in that** a multilayer system (2) transparent to visible light is applied between the surface of the pane (1.1) and the contact surface (3) or on top of the contact surface provided with the cutout, which multilayer system comprises at least one electrically conducting layer that is connected in an electrically conducting manner to the contact surface (3).

7. The pane as claimed in claim 6, the multilayer system (2) of which is used as a surface heater and has an electrical contact.

8. The pane as claimed in claim 6 or 7, the multilayer system (2) of which is used as an antenna and has an electrical contact.

9. The pane (1.1) as claimed in one of the preceding claims, incorporated as a rigid pane in a composite glazing panel (1), the contact surface (3) at least and the soldering location both being located on the inside of the multipane composite.

10. A composite glazing panel (1) having a first rigid pane (1.1) as claimed in any one of the preceding claims and at least a second rigid pane (1.2), **characterized in that** the second rigid pane (1.2) is provided with an opaque coating (6) that covers the contact surface (3) and optically masks it.

## Patentansprüche

1. Durchsichtige Scheibe (1.1), insbesondere Glasscheibe, mit mindestens einer auf einer ihrer Oberflächen angeordneten undurchsichtigen, elektrisch leitfähigen Kontaktfläche (3) für einen durch Weichlöten zu verbindenden Anschluss (4), **dadurch gekennzeichnet, dass** die Kontaktfläche (3) im Bereich der Lötstelle mindestens eine Aussparung (3A) aufweist, in welcher das Lot (5) nach dem Auflöten des Anschlusses (4) auf die Kontaktfläche (3) durch die Scheibe (1.1) hindurch sichtbar ist.

2. Scheibe nach Anspruch 1, **dadurch gekennzeichnet, dass** auf ihrer Oberfläche mehrere Kontaktflächen und/oder mehrere Aussparungen in jeder Kontaktfläche vorgesehen sind.

3. Scheibe nach Anspruch 1 oder 2, **dadurch gekennzeichnet, dass** das Lot (5) sich nach dem Löten auf der Kontaktfläche (3) und in der Aussparung oder den Aussparungen (3A) ausgebreitet hat.

4. Scheibe nach einem der vorstehenden Ansprüche, **dadurch gekennzeichnet, dass** der Anschluss (4) vor dem Löten mit Lotdepots (5) in Form von Tropfen oder dünnen Schichten versehen wird.

5. Scheibe nach einem der vorstehenden Ansprüche, **dadurch gekennzeichnet, dass** die Kontaktfläche (3) vor dem Löten vorzugsweise rund um die Aussparung oder die Aussparungen herum, mit Lotdepots (5) in Form von Tropfen oder dünnen Schichten versehen wird.

6. Scheibe nach einem der vorstehenden Ansprüche, **dadurch gekennzeichnet, dass** zwischen der Oberfläche der Scheibe (1.1) und der Kontaktfläche (3) oder über die mit der Aussparung versehene Kontaktfläche ein sichtbares Licht durchlassendes Schichtsystem (2) aufgebracht ist, das mindestens eine elektrisch leitfähige und mit der Kontaktfläche (3) elektrisch leitend verbundene Schicht umfasst.

7. Scheibe nach Anspruch 6, deren Schichtsystem (2) als Flächenheizung verwendet und elektrisch kontaktiert wird.

8. Scheibe nach Anspruch 6 oder 7, deren Schichtsystem (2) als Antenne verwendet und elektrisch kontaktiert wird.

9. Scheibe (1.1) nach einem der vorstehenden Ansprüche, die als starre Scheibe in eine Verbundscheibe (1) eingebaut ist, wobei die mindestens eine Kontaktfläche (3) und die Lötstelle innerhalb des Scheibenverbundes liegen.

10. Verbundscheibe (1) mit einer ersten starren Scheibe (1.1) nach einem der vorstehenden Ansprüche und mit mindestens einer weiteren starren Scheibe (1.2), **dadurch gekennzeichnet, dass** die zweite starre Scheibe (1.2) mit einer die Kontaktfläche (3) überdeckenden und optisch kaschierenden opaken Beschichtung (6) versehen ist.
